# EUROPÄISCHE PATENTSCHRIFT

(11) **EP 0 727 897 B1**
(45) Veröffentlichungstag und Bekanntmachung des Hinweises auf die Patenterteilung: **31.05.2006**
(21) Anmeldenummer: 95102169.0
(22) Anmeldetag: 16.02.1995
(51) Int. Cl.: H04L 25/06, H03K 5/153

(54) **Schaltungsanordnung für den Empfang eines in Form einer Spannungspegeländerung über einen Bus übertragenen Signals**
Circuit for receiving a signal transmitted on a bus as voltage level variations
Circuit de réception d'un signal transmis sur un bus comme variations d'un niveau de tension

(43) Veröffentlichungstag der Anmeldung: 21.08.1996
(73) Patentinhaber: TEXAS INSTRUMENTS DEUTSCHLAND GMBH, 85356 Freising (DE)
(72) Erfinder: Kiml, Helmut, D-84184 Tiefenbach (DE)
(74) Vertreter: Degwert, Hartmut

(56) Entgegenhaltungen:
- DE-A- 3 325 411
- DE-A- 4 205 352
- US-A- 4 229 831

## Beschreibung

Die Erfindung betrifft eine Schaltungsanordnung für den Empfang eines in Form einer Spannungspegeländerung über einen Bus übertragenen Signals.

US 4,229,831 betrifft eine Schaltung zur Erkennung positiver und negativer Signalflanken, wobei die positiven Flanken und die negativen Flanken jeweils zeitgleich als Impulse in einer Auswerteeinheit umgesetzt werden.

DE 42 05 352 betrifft eine Vorrichtung und ein Verfahren zum Gewinnen von Impulssignalen, bei dem ein Ausgangsimpulssignal erzeugt werden kann, auch wenn das Eingangsimpulssignal aufgrund einer niederfrequenten Brummspannungskomponente stark pulsiert.

Busse werden in der Regel als gemeinsamer Übertragungsweg für einen Datenaustausch zwischen zwei oder mehreren angeschlossenen elektronischen Geräten eingesetzt. In entsprechenden Bus-Systemen können insbesondere Adreß-, Daten- und/oder Steuer-Signale übertragen werden. Entscheidend für eine möglichst fehlerfreie Kommunikation zwischen den einzelnen Geräten ist unter anderem, daß diese über den Bus zu empfangende Signale sicher erkennen. Hierzu werden bei bekannten unsymmetrisch angesteuerten Zweidraht-Bus-Systemen Komparatoren verwendet, durch die das Empfangssignal direkt mit einem festen Bezugssignal verglichen wird. Bei symmetrisch angesteuerten Zweidraht-Bus-Systemen wird ein solcher

Vergleich mit einem festen Bezugssignal beispielsweise dann vorgenommen, wenn eine der beiden Leitungen ausfällt und die Übertragung demzufolge ausschließlich über die intakte Leitung erfolgen soll. In diesem Fall wird der feste Bezugsspannungspegel an den der fehlerhaften Leitung zugeordneten Eingang des in dem Bus-System verwendeten Komparators angelegt.

Problematisch bei diesen herkömmlichen Bus-Systemen ist nun aber, daß eine beispielsweise durch Einstreuungen bedingte Verschiebung des Massepegels die Signalerkennung erschweren oder sogar verhindern kann. Insbesondere kann nicht ausgeschlossen werden, daß sich der Massepegel bis in den Bereich des festen Bezugssignalpegels verschiebt. Zumindest im letzteren Fall ist eine eindeutige Signalerkennung praktisch ausgeschlossen.

Ziel der Erfindung ist es, eine Schaltungsanordnung der eingangs genannten Art zu schaffen, die bei einfachstem Aufbau eine möglichst störungssichere Signalerkennung gewährleistet.

Diese Aufgabe wird nach der Erfindung durch die im Patentanspruch 1 angegebene Schaltungsanordnung gelöst.

Demnach wird das empfangene Signal erfindungsgemäß anhand auftretender positiver und/oder negativer Flanken erfaßt, wobei die mit einer solchen Flanke auftretende sprungartige Spannungspegeländerung mit einem kontinuierlich an den jeweiligen Ruhespannungspegel des Busses angepaßten Bezugsspannungspegel verglichen wird. Der vorgegebene relative Schwellenwert, um den sich der am Bus anliegende Spannungspegel im Verlauf eines solchen Pegelsprunges gegenüber dem automatisch angepaßten Bezugsspannungspegel ändern muß, wird zweckmäßigerweise kleiner als die das Signal normalerweise definierende Spannungspegeländerung gewählt. Das für ein jeweiliges Bus-Signal repräsentative Ausgangssignal wird durch die Auswerteschaltung erzeugt, nachdem eine jeweilige Signalflanke anhand der angegebenen Kriterien zuverlässig erfaßt wurde. Aufgrund der erfindungsgemäßen Ausbildung wird die Störsicherheit wesentlich erhöht. Während einerseits ausgeschlossen ist, daß langsamere Pegeländerungen fälschlicherweise als Signalflanken interpretiert werden, ist andererseits durch die ständige automatische Anpassung des Bezugsspannungspegels an den Ruhespannungspegel des Busses gewährleistet, daß insbesondere auch bei einer eventuellen Verschiebung des Massepegels stets eine einwandfreie Signalerkennung erfolgt.

Um auszuschließen, daß beispielsweise durch Einstreuungen bedingte Pegelspitzen und/oder -einbrüche als Signale interpretiert werden, ist vorgesehen, daß die Auswerteschaltung das Ausgangssignal nur erzeugt oder zurücknimmt, wenn nach dem Erfassen einer betreffenden Signalflanke der am Bus anliegende Spannungspegel während einer vorgegebenen Mindestzeitdauer um wenigstens den vorgegebenen relativen Schwellenwert vom Bezugsspannungspegel abweicht. Diese Mindestzeitdauer ist zweckmäßigerweise größer als die Zeitkonstante gewählt, mit der der Bezugsspannungspegel an den Ruhespannungspegel des Busses angepaßt wird. Damit ist unter anderem sichergestellt, daß die nächste am Bus auftretende Pegeländerung in jedem Fall mit dem aktualisierten Bezugsspannungspegel verglichen wird.

Wegen des symmetrisch angesteuerten Zweidraht-Busses sind den verschiedenen Busleitungen getrennte Flankendetektoren zugeordnet, die mit einer gemeinsamen Auswerteschaltung verbunden sind. Hierbei kann die Schaltungsanordnung eine die verschiedenen Busleitungen auf ihre Funktionsfähigkeit hin überprüfende Fehlererkennungs- und -anzeigeeinrichtung enthalten, wobei sie bei Ausfall einer Busleitung vorzugsweise automatisch auf einen Einleitungs-Betrieb übergeht.

Gemäß einer bevorzugten Ausführungsvariante enthält der Flankendetektor ein Speicherelement und eine Ladeschaltung, durch die das Speicherelement auf den Ruhespannungspegel des Busses aufladbar ist, um den Bezugsspannungspegel zu erzeugen. Hierbei enthält der Flankendetektor ferner einen Komparator, der den am Bus anliegenden Spannungspegel mit dem Bezugsspannungspegel vergleicht, um das für das Auftreten einer Signalflanke repräsentative Signal zu liefern, wenn der am Bus anliegende Spannungspegel um wenigstens den vorgegebenen relativen Schwellenwert von dem Bezugsspannungspegel abweicht.

Die Ladeschaltung enthält vorzugsweise einen Differenzverstärker und einen zwischen dessen Ausgang und Masse liegenden Serienkreis aus einem auf der Seite des Verstärkerausgangs vorgesehenen ersten Widerstand und einer an Masse liegenden, das Speicherelement bildenden Kondensator, wobei ein erster Eingang des Differenzverstärkers von dem am Bus anliegenden Spannungspegel beaufschlagt und dessen zweiter Eingang mit dem den Bezugsspannungspegel liefernden Schaltungspunkt zwischen dem ersten Widerstand und dem Kondensator verbunden ist, während zwischen den ersten Eingang des Differenzverstärkers und Masse ein Serienkreis aus einer auf der Seite des Verstärkereingangs vorgesehenen, den relativen Schwellenwert bestimmenden Diode und einem an Masse liegenden zweiten Widerstand geschaltet ist. Dabei ist ein erster Eingang des Komparators mit dem zwischen der Diode und dem zweiten Widerstand liegenden Schaltungspunkt und dessen zweiter Eingang mit dem zwischen dem ersten Widerstand und dem Kondensator liegenden Schaltungspunkt verbunden. Der Flankendetektor liefert demnach ein impulsartiges Signal, dessen Breite durch die Zeit bestimmt ist, die benötigt wird, den Kondensator C auf einen Pegel aufzuladen, der um den vorgegebenen Schwellenwert unter dem geänderten Bus-Pegel liegt. Zudem bestimmt die Zeitkonstante des ersten RC-Serienkreises die Geschwindigkeit der Anpassung des Bezugsspannungspegels an den am Bus anliegenden Spannungspegel. Sie ist vorzugsweise kleiner gewählt als die vorzugsweise vorgesehene Mindestzeitdauer, während der der am Bus anliegende Spannungspegel um wenigstens den durch die Diode vorgegebenen relativen Schwellenwert vom Bezugsspannungspegel abweichen muß, damit die Auswerteschaltung das Ausgangssignal erzeugt.

Vorteilhafterweise sind jeder signalführenden Busleitung zwei Flankendetektoren zugeordnet, von denen einer ein für das Auftreten einer positiven Signalflanke repräsentative Signal und der andere ein für das Auftreten einer negativen Signalflanke repräsentative Signal liefert.

Die Erfindung wird im folgenden anhand eines Ausführungsbeispiels unter Bezugnahme auf die Zeichnung näher erläutert; in dieser zeigen:
Figur 1 ein vereinfachtes schematisches Blockschaltbild einer einem symmetrisch angesteuerten Zweidraht-Bus zugeordneten Schaltungsanordnung für den Empfang von über den Bus übertragenen Signalen,
Figur 2 ein Prinzipschaltbild eines in der Schaltungsanordnung nach Figur 1 verwendeten Flankendetektors, und
Figur 3 Diagramme von Signalen an verschiedenen Punkten der Schaltungsanordnung und des Flankendetektors nach Figur 1 bzw. 2.

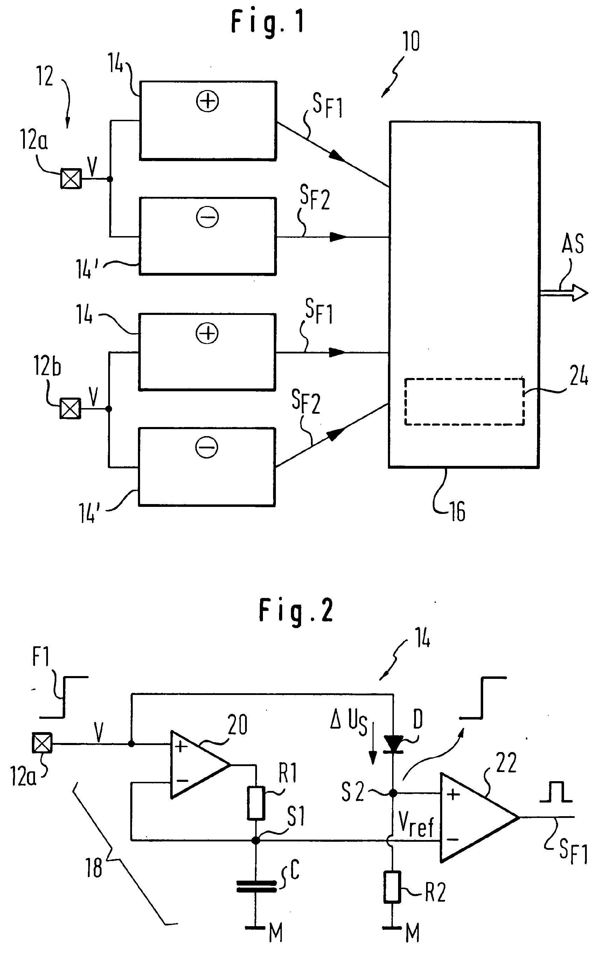

Die in Figur 1 dargestellte Schaltungsanordnung 10 dient dem Empfang von Signalen, die über einen symmetrisch angesteuerten Zweidraht-Bus 12 übertragen werden. Bei einer solchen symmetrischen Übertragung gibt man komplementäre Signale auf die beiden Drähte oder Busleitungen 12a, 12b.

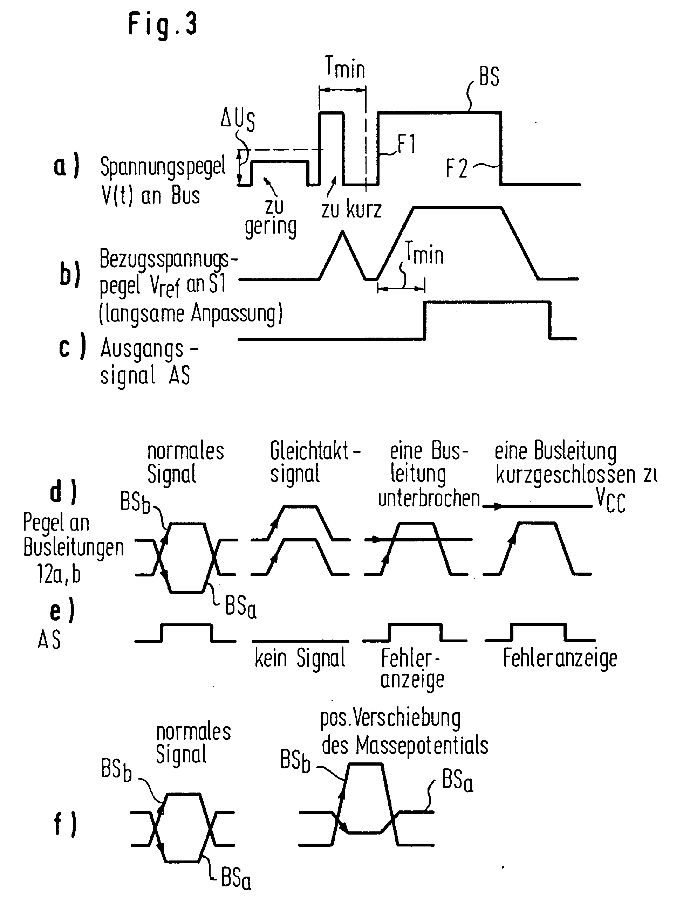

Jeder der beiden signalführenden Busleitungen 12a, 12b, sind zwei Flankendetektoren 14, 14' zugeordnet. Hierbei liefert der Flankendetektor 14 eines jeweiligen Detektorpaares ein für das Auftreten einer positiven Signalflanke F1 (vgl. auch Figur 3) repräsentative Signal S_{F1}, während der andere Flankendetektor 14' ein für das Auftreten einer negativen Signalflanke F2 repräsentative Signal S_{F2} liefert.

Während die Eingänge eines jeweiligen Flankendetektorpaares 14, 14' miteinander und mit der betreffenden Busleitung 12a bzw. 12b verbunden sind, sind die Ausgänge der Flankendetektoren 14, 14' an getrennte Eingänge einer gemeinsamen Auswerteschaltung 16 angeschlossen. Diese gemeinsame Auswerteschaltung 16 erhält somit die von den vier Flankendetektoren 14, 14' gelieferten, für das Auftreten einer positiven Signalflanke F1 bzw. einer negativen Signalflanke F2 repräsentativen Signale S_{F1}, S_{F2}. Ausgehend von diesen vier Detektorsignalen erzeugt die gemeinsame Auswerteschaltung 16 ein für das in komplementärer Form über die beiden Busleitungen 12a, 12b übertragene Bus-Signal BS (vgl. auch Fig. 3) repräsentatives Ausgangssignal AS.

Jeder der in Figur 1 gezeigten Flankendetektoren 14, 14' ist so ausgelegt, daß er das für das Auftreten der betreffenden Signalflanke F1, F2 repräsentative Signal S_{F1}, S_{F2} liefert, wenn sich der an der betreffenden Busleitung 12a, 12b anliegende Spannungspegel V sprungartig um wenigstens einen vorgegebenen relativen Schwellenwert ΔU_{S} (vgl. auch Figur 3) gegenüber einem kontinuierlich an den Ruhespannungspegel der Busleitung 12a, 12b angepaßten Bezugsspannungspegel V_{ref} ändert.

Figur 2 zeigt das Schaltbild eines in der Schaltungsanordnung 10 der Figur 1 verwendeten Flankendetektors 14 zur Erzeugung eines für das Auftreten einer positiven Signalflanke F1 repräsentativen Signals S_{F1}.

Dieser Flankendetektor 14 enthält als Speicherelement einen Kondensator C sowie eine Ladeschaltung 18, durch die der Kondensator C auf den Ruhespannungspegel der Busleitung 12a aufladbar ist, um den jeweiligen Bezugsspannungspegel V_{ref} zu erzeugen.

Die Ladeschaltung 18 ist durch einen Differenzverstärker 20 und einen zwischen dessen Ausgang und Masse M liegenden Serienkreis R1, C aus einem an den Verstärkerausgang angeschlossenen ersten Widerstand R1 und dem an Masse M liegenden, das Speicherelement bildenden Kondensator C gebildet. Der positive Eingang des Differenzverstärkers 20 ist an die Busleitung 12a angeschlossen, während dessen negativer Eingang mit dem den Bezugsspannungspegel V_{ref} liefernden Schaltungspunkt S1 zwischen dem ersten Widerstand R1 und dem Kondensator C verbunden ist. Zwischen den positiven Eingang des Differenzverstärkers 20 und Masse M ist ein Serienkreis D, R2 aus einer anodenseitig an den positiven Eingang des Differenzverstärkers 20 angeschlossenen Diode D und einem an Masse M liegenden zweiten Widerstand R2 geschaltet.

Der Flankendetektor 14 enthält ferner einen Komparator 22, der den an der Busleitung 12a anliegenden Spannungspegel V mit dem Bezugsspannungspegel V_{ref} vergleicht, um an seinem Ausgang das für das Auftreten der positiven Signalflanke F1 repräsentative Signal S_{F1} zu liefern, wenn der an der Busleitung 12a anliegende Spannungspegel V um wenigstens den durch die Durchlaßspannung der Diode D bestimmten vorgegebenen relativen Schwellenwert ΔU_{S} von dem Bezugsspannungspegel V_{ref} abweicht.

Dazu ist der positive Eingang des Komparators 22 mit dem zwischen der Diode D und dem zweiten Widerstand R2 liegenden Schaltungspunkt S2 verbunden, während dessen negativer Eingang mit dem zwischen dem ersten Widerstand R1 und dem Kondensator C liegenden Schaltungspunkt S1 verbunden ist.

Die in der Schaltungsanordnung 10 verwendeten Flankendetektoren 14' zur Erzeugung eines für das Auftreten einer negativen Signalflanke F2 repräsentativen Signals S_{F2} sind in vergleichbarer Weise aufgebaut, wobei jedoch vorzugsweise die Diode D mit umgekehrter Polarität zwischen den Differenzverstärker 20 und den Komparator 22 eingesetzt wird, der Widerstand R2 anstatt an Masse M an V_{CC} gelegt wird und die Eingänge des Komparators 22 vertauscht werden.

Die Funktionsweise der erfindungsgemäßen Schaltungsanordnung wird im folgenden näher erläutert, wobei auch auf die in Figur 3 gezeigten Pegeldiagramme Bezug genommen wird.

Betrachtet man beispielsweise den in Figur 2 dargestellten Flankdetektor 14 zur Erzeugung eines für das Auftreten einer positiven Signalflanke F1 repräsentativen Signals S_{F1}, so wird der Kondensator C entsprechend der Zeitkonstanten τ = R1 * C auf den jeweiligen Ruhespannungspegel der Busleitung 12a aufgeladen. Der Differenzverstärker 20 bewirkt nämlich, daß der Kondensator C über den Widerstand R1 stets soweit aufgeladen wird, daß die zwischen seinen beiden Eingängen auftretende Differenzspannung Null wird. Sobald dieser Zustand erreicht ist, weist der mit dem negativen Eingang des Differenzverstärkers verbundene Schaltungspunkt S1 den gleichen Spannungspegel wie der mit der Busleitung 12a verbundene positive Eingang auf.

Wie sich anhand der Diagramme a) und b) der Figur 3 ergibt, die den an der Busleitung 12a anliegenden Spannungspegel V bzw. den am Schaltungspunkt S1 anliegenden Bezugsspannungspegel V_{ref} über der Zeit t zeigen, ist die Anstiegszeit der positiven Flanke F1 eines jeweiligen Bus-Signals BS deutlich kleiner als die Zeitkonstante τ, mit der der Bezugsspannungspegel V_{ref} an den jeweiligen Ruhespannungspegel der Busleitung 12a angepaßt bzw. der Kondensator C aufgeladen wird.

Tritt nun an der Busleitung 12a die positive Flanke F1 eines Bus-Signals BS auf, so fließt über die Diode D und den zweiten Widerstand R2 ein Strom, der an dem zweiten Widerstand R2 zu einem Spannungsabfall führt, durch den der Spannungspegel an dem Schaltungspunkt S2 entsprechend angehoben wird. Der Spannungspegel an diesem mit dem positiven Eingang des Komparators 22 verbundenen Schaltungspunkt S2 ist um die Durchlaßspannung der Diode D geringer als der an der Busleitung 12a anliegende Spannungspegel V. Die Durchlaßspannung der Diode D bestimmt somit den vorgegebenen relativen Schwellenwert ΔU_{S}, um den der an der Busleitung 12a anliegende Spannungspegel V größer als der Bezugsspannungspegel V_{ref} sein muß, damit zwischen den beiden Eingängen des Komparators 22 eine positive Differenzspannung erzeugt wird und der Komparator 22 ein für das Auftreten der positiven Signalflanke F1 repräsentatives Signal S_{F1} liefert.

Mit dem Auftreten der positiven Signalflanke F1 ergibt sich wieder eine positive Differenzspannung zwischen den beiden Eingängen des Differenzverstärkers 20, so daß der Kondensator C entsprechend der Zeitkonstanten τ weiter aufgeladen wird, bis der an dem Schaltungspunkt S1 abgegriffene Bezugsspannungspegel V_{ref} den Wert des nunmehr an der Busleitung 12a anliegenden höheren Spannungspegels erreicht hat.

Die Differenzspannung zwischen den beiden Eingängen des Komparators 22 wird wieder Null, wenn der Kondensator C auf einen Spannungspegel aufgeladen ist, der um die Durchlaßspannung der Diode D, d.h. den Schwellenwert ΔU_{S} geringer als der an der Busleitung 12a anliegende Spannungspegel V ist. Ist dieser Zustand erreicht, so wird der Ausgang des Komparators 22 zurückgesetzt. Dieser Komparator 22 liefert demzufolge ein impulsförmiges Signal S_{F1}, dessen Impulsbreite unter anderem von der Zeitkonstanten τ des den ersten Widerstand R₁ und den Kondensator C enthaltenden Serienkreises abhängig ist.

Nimmt das Bus-Signal BS wieder den niedrigeren Spannungspegel an, so bleibt der am Schaltungspunkt S2 anliegende Spannungspegel auch weiterhin kleiner als der Bezugsspannungspegel V_{ref}, so daß das Ausgangssignal S_{F1} des Komparators 22 auf dem niedrigeren Pegel gehalten wird. Indessen wird der Kondensator C entsprechend der Zeitkonstanten τ auf den aktuellen Ruhespannungspegel der Busleitung 12a entladen.

Der soeben beschriebene Flankendetektor 14 liefert somit ein für das Auftreten einer positiven Signalflanke F1 repräsentatives impulsförmiges Signal S_{F1}, das der Auswerteschaltung 16 zur weiteren Verarbeitung zugeführt wird.

Entsprechend liefern die einen vergleichbaren Aufbau aufweisenden Flankendetektoren 14' der in Figur 1 gezeigten Schaltungsanordnung 10 jeweils ein für das Auftreten einer negativen Signalflanke F2 repräsentative Signal S_{F2}, das ebenfalls zur weiteren Verarbeitung der gemeinsamen Auswerteschaltung 16 zugeführt wird (vgl. Figur 1). Diese zur Erfassung der negativen Signalflanken F2 dienenden Flankendetektoren 14' werden vorzugsweise dadurch erhalten, daß die Diode D mit umgekehrter Polarität zwischen den Differenzverstärker 20 und den Komparator 22 eingesetzt, der Widerstand R2 anstatt an Masse M an Vcc gelegt und die Eingänge des Komparators 22 vertauscht werden.

Das Diagramm c) der Figur 3 zeigt den zeitlichen Verlauf des von der Auswerteschaltung 16 gelieferten, für das Bus-Signal BS repräsentativen Ausgangssignals AS. Aus einem Vergleich mit den Zeitdiagrammen a) und b) ergibt sich, daß die Auswerteschaltung 16 das Ausgangssignal AS erst erzeugt, wenn nach dem Erfassen der positiven Signalflanke F1 der an der Busleitung 12a anliegende Spannungspegel V während einer vorgegebenen Mindestzeitdauer Tₘᵢₙ um wenigstens den vorgegebenen relativen Schwellenwert ΔU_{S} vom Bezugsspannungspegel V_{ref} abweicht.

Entsprechend nimmt die Auswerteschaltung 16 das Ausgangssignal AS erst zurück, wenn nach dem Erfassen einer negativen Signalflanke F2 durch einen Flankendetektor 14' der an der Busleitung 12a anliegende Spannungspegel V während der vorgegebenen Mindestzeitdauer Tₘᵢₙ um wenigstens den vorgegebenen relativen Schwellenwert ΔU_{S} geringer als der Bezugsspannungspegel V_{ref} ist.

Anhand der Diagramme a) bis c) ist auch zu erkennen, daß die Auswerteschaltung 16 kein Ausgangssignal AS erzeugt, solange der an der Busleitung 12a bzw. 12b anliegende Spannungspegel V sich im Verlauf einer sprungartigen Pegeländerung lediglich um einen Wert ändert, der kleiner als der vorgegebene relative Schwellenwert ΔU_{S} ist.

Im Zeitdiagramm a) wird dieser relative Schwellenwert ΔU_{S} von dem zweiten Bus-Impuls zwar überschritten, hierbei ist die Impulsbreite jedoch geringer als die Mindestzeitdauer Tₘᵢₙ, während der der am Bus 12 anliegende Spannungspegel V um wenigstens den vorgegebenen relativen Schwellenwert ΔU_{S} vom Bezugsspannungspegel V_{ref} abweichen muß, damit die Auswerteschaltung 16 das Ausgangssignal AS erzeugt.

Wie sich aus dem Zeitdiagramm b) ergibt, ist der Kondensator C nach der kurzen Zeitdauer des zweiten Impulses noch nicht auf den vollen Wert entsprechend dem neuen Ruhespannungspegel aufgeladen. Das im Diagramm c) dargestellte Ausgangssignal AS wird erst erzeugt, nachdem der Schwellenwert ΔU_{S} überschritten wurde und die vorgegebene Mindestzeitdauer Tₘᵢₙ verstrichen ist.

Den Zeitdiagrammen a) bis c) kann auch entnommen werden, daß die Zeitkonstante τ, mit der der Bezugsspannungspegel V_{ref} an den Ruhespannungspegel des Busses 12 angepaßt bzw. der Kondensator C aufgeladen oder entladen wird, kleiner ist als die vorgegebene Mindestzeitdauer Tₘᵢₙ.

Nachdem ein jeweiliges Bus-Signal BS durch die Flankendetektoren 14, 14' lediglich anhand seiner Flanken erfaßt wird, muß es in der Auswerteschaltung 16 gespeichert bzw. regeneriert werden. Dies erfolgt in Abhängigkeit von den von den Flankendetektoren 14, 14' gelieferten Signalen S_{F1}, S_{F2}.

Nachdem die Schaltungsanordnung 10 beim dargestellten Ausführungsbeispiel für einen symmetrisch angesteuerten Zweidraht-Bus 12 vorgesehen ist, werden in der Auswerteschaltung 16 zweckmäßigerweise auch die Signale S_{F1}, S_{F2} der den unterschiedlichen Busleitungen 12a, 12b zugeordneten Flankendetektorpaaren miteinander kombiniert. Werden über die beiden Busleitungen 12a, 12b beispielsweise komplementäre Signale übertragen, so kann in der Auswerteschaltung 16 zweckmäßigerweise wenigstens ein weiterer Komparator oder Differenzverstärker bzw. eine entsprechende Logik vorgesehen sein, um die von den komplementären Bus-Signalen abgeleiteten Zwischensignale miteinander zu vergleichen. Die jeweilige Information wird dann vorzugsweise durch eine Differenzspannung anstatt durch einen absoluten Pegelwert charakterisiert, was dazu führt, daß ein Störimpuls lediglich eine Gleichtaktaussteuerung bewirkt, die aufgrund der Differenzbildung des betreffenden Komparators wirkungslos bleibt.

Die Auswerteschaltung 16 kann auch eine die verschiedenen Busleitungen 12a, 12b auf ihre Funktionsfähigkeit hin überprüfende Fehler-Erkennungs- und -anzeigeeinrichtung 24 enthalten und so ausgelegt sein, daß die Schaltungsanordnung 10 bei Ausfall einer Busleitung 12a, 12b auf einen Einleitungs-Betrieb umschaltbar ist. Diese Umschaltung erfolgt zweckmäßigerweise automatisch.

In den Diagrammen d) und e), die den zeitlichen Verlauf der Spannungspegel der beiden komplementären Bus-Signale BSₐ, BS_{b} bzw. den Spannungspegel des Ausgangssignals AS zeigen, sind einige Beispiele für den Betrieb im Zusammenhang mit einem symmetrisch angesteuerten Zweidraht-Bus wiedergegeben.

Im Falle einer normalen Signalübertragung treten auf den beiden Busleitungen 12a, 12b zeitgleich zwei komplementäre Bus-Signale BSₐ, BS_{b} auf. Entsprechend wird durch die Auswerteschaltung 16 ein für dieses Bus-Signal BS repräsentatives Ausgangssignal AS erzeugt.

Beim zweiten dargestellten Beispiel tritt auf den beiden Busleitungen 12a, 12b ein Störsignal auf, das jedoch lediglich eine Gleichtaktaussteuerung bewirkt, die aufgrund der Differenzbildung eines in der Auswerteschaltung 16 zusätzlich vorgesehenen Komparators wirkungslos bleibt. Demnach wird kein Ausgangssignal AS erzeugt.

Im dritten Fall ist die Busleitung 12a unterbrochen, so daß automatisch auf einen Einleitungs-Betrieb umgeschaltet und das Ausgangssignal AS anhand der Signale des der intakten Busleitung 12b zugeordneten Flankendetektorpaares 14, 14' erzeugt wird. Gleichzeitig kann die Fehlererkennungs- und Anzeigeeinrichtung 24 den Fehler anzeigen.

Im letzten Fall ist die Busleitung 12a nach V_{CC} kurzgeschlossen. Auch in diesem Fall wird automatisch auf einen Einleitungs-Betrieb umgeschaltet und das Ausgangssignal AS anhand der Signale des der intakten Busleitung 12b zugeordneten Flankendetektorpaares 14, 14' erzeugt. Der Fehler wird wiederum über die Fehlererkennungs- und -anzeigeeinrichtung 24 angezeigt.

Im Diagramm f) der Figur 3 ist dem Fall einer normalen Signalübertragung und eines normalen Signalempfangs der Fall gegenübergestellt, bei dem beim Empfang des über die Busleitung 12b übertragenen Signals eine positive Verschiebung des Massepotentials auftritt. Nachdem jedes Bus-Signal über Flankendetektoren erfaßt wird, in denen das Bus-Signal mit einem kontinuierlich an den jeweiligen Ruhespannungspegel des Busses angepaßten Bezugsspannungspegel verglichen wird, ist dennoch ein fehlerfreier Empfang gewährleistet. Zudem kann die Schaltungsanordnung 10 bei einem völligen Ausfall der Busleitung 12a in der oben beschriebenen Weise auf einen Einleitungs-Betrieb umgeschaltet werden.

Die zuvor im Zusammenhang mit einem möglichen Ausfall der Busleitung 12a beschriebene Funktionsweise der Schaltungsanordnung 10 entspricht der im Fall einer möglichen Störung der anderen Busleitung 12b. Im letzteren Fall wird dann auf einen Einleitungs-Betrieb umgeschaltet, bei dem die über die ungestörte Busleitung 12a empfangenen Signale ausgewertet werden.

Die beschriebene Schaltungsanordnung ist grundsätzlich auch für einen Eindraht-Betrieb oder ein unsymmetrisch angesteuertes Bus-System geeignet. In diesem Fall genügt die Verwendung eines der beiden in Figur 1 gezeigten Flankendetektorpaare 14, 14'.

Grundsätzlich ist es auch möglich, für eine jeweilige Busleitung nur einen Flankendetektor vorzusehen, der sowohl das für das Auftreten der positiven Signalflanke als auch das für das Auftreten der negativen Signalflanke repräsentative Signal liefert.

## Patentansprüche

1. Schaltungsanordnung (10) für den Empfang eines in Form einer Spannungspegeländerung über einen Bus (12) mit zwei signalführenden Busleitungen (12a, 12b) übertragenen Signals (BS) mit folgenden Merkmalen:
a) jeder signalführenden Busleitung (12a, 12b) sind zwei Flankendetektoren (14, 14') zugeordnet, von denen einer ein für das Auftreten einer positiven Signalflanke (F1) repräsentatives Signal (S_{F1}) und der andere ein für das Auftreten einer negativen Signalflanke (F2) repräsentatives Signal (S_{F2}) liefert;
b) die Flankendetektoren (14, 14') liefern ein für das Auftreten einer Signalflanke (F1, F2) repräsentatives Signal (S_{F1}, S_{F2}), wenn sich der am Bus (12) anliegende Spannungspegel (V) sprungartig um wenigstens einen vorgegebenen relativen Schwellenwert (ΔU_{S}) gegenüber einem Bezugsspannungspegel (V_{ref}) ändert;
c) der Bezugsspannungspegel (V_{ref}) wird kontinuierlich an den Ruhespannungspegel des Busses (12) angepaßt;
d) den Flankendetektoren (14, 14') ist eine Auswerteschaltung (16) nachgeschaltet, die ausgehend von dem von Flankendetektoren (14, 14') gelieferten Signalen (S_{F1}, S_{F2}) ein für das Bus-Signal (BS) repräsentatives Ausgangssignal (AS) erzeugt;
e) die Auswerteschaltung (16) erzeugt das Ausgangssignal (AS) nur, wenn nach dem Erfassen einer betreffenden Signalflanke (F1) der am Bus (12) anliegende Spannungspegel (V) während einer vorgegebenen Mindestzeitdauer (Tₘᵢₙ) um wenigstens den vorgegebenen relativen Schwellenwert (ΔU_{S}) vom Bezugsspannungspegel (V_{ref}) abweicht; und
f) die Auswerteschaltung (16) nimmt das Ausgangssignal (AS) nur zurück, wenn nach dem Erfassen einer betreffenden Signalflanke (F2) der am Bus (12) anliegende Spannungspegel (V) während einer vorgegebenen Mindestzeitdauer (Tₘᵢₙ) um wenigstens den vorgegebenen relativen Schwellenwert (ΔU_{S}) vom Bezugsspannungspegel (V_{ref}) abweicht.

2. Schaltungsanordnung (10) nach Anspruch 1, **dadurch gekennzeichnet, daß** der Flankendetektor (14, 14') ein Speicherelement (C) und eine Ladeschaltung (18) enthält, durch die das Speicherelement (C) auf den Ruhespannungspegel des Busses (12) aufladbar ist, um den Bezugsspannungspegel (V_{ref}) zu erzeugen, und daß der Flankendetektor (14, 14') ferner einen Komparator (22) enthält, der den am Bus (12) anliegenden Spannungspegel (V) mit dem Bezugsspannungspegel (V_{ref}) vergleicht, um das für das Auftreten einer Signalflanke (F1, F2) repräsentative Signal (S_{F1}, S_{F2}) zu liefern, wenn der am Bus (12) anliegende Spannungspegel (V) um wenigstens den vorgegebenen relativen Schwellenwert (ΔU_{S}) von dem Bezugsspannungspegel (V_{ref}) abweicht.

3. Schaltungsanordnung (10) nach einem der vorhergehenden Ansprüche, **dadurch gekennzeichnet, daß** die Ladeschaltung (18) einen Differenzverstärker (20) und einen zwischen dessen Ausgang und Masse (M) liegenden Serienkreis (R1, C) aus einem auf der Seite des Verstärkerausgangs vorgesehenen ersten Widerstand (R1) und einer an Masse (M) liegenden, das Speicherelement bildenden Kondensator (C) enthält, daß ein erster Eingang des Differenzverstärkers (20) von dem am Bus (12) anliegenden Spannungspegel (V) beaufschlagt und dessen zweiter Eingang mit dem den Bezugsspannungspegel (V_{ref}) liefernden Schaltungspunkt (S1) zwischen dem ersten Widerstand (R1) und dem Kondensator (C) verbunden ist, daß zwischen den ersten Eingang des Differenzverstärkers (20) und Masse (M) ein Serienkreis (D, R2) aus einer auf der Seite des Verstärkereingangs vorgesehenen, den relativen Schwellenwert (ΔU_{S}) bestimmenden Diode (D) und einem an Masse (M) liegenden zweiten Widerstand (R2) geschaltet ist und daß ein erster Eingang des Komparators (22) mit dem zwischen der Diode (D) und dem zweiten Widerstand (R2) liegenden Schaltungspunkt (S2) und dessen zweiter Eingang mit dem zwischen dem ersten Widerstand (R1) und dem Kondensator (C) liegenden Schaltungspunkt (S1) verbunden ist.

## Claims

1. A circuit arrangement (10) for the reception of a signal (BS) transmitted in the form of a voltage level change via a bus (12) having two signal-carrying bus lines (12a, 12b), including the following features:
(a) each signal-carrying bus line (12a, 12b) has two edge detectors (14, 14') associated therewith, one of which supplies a signal (S_{F1}) representative of the occurrence of a positive signal edge (F1) and the other supplies a signal (S_{F2}) representative of the occurrence of a negative signal edge (F2);
(b) the edge detectors (14, 14') supply a signal (S_{F1}, S_{F2}) representative of the occurrence of a signal edge (F1, F2) when the voltage level (V) present at the bus (12) abruptly changes by at least a predetermined relative threshold value (ΔU_{S}) in relation to a reference voltage level (V_{ref});
(c) the reference voltage level (V_{ref}) is continuously adapted to the quiescent voltage level of the bus (12);
(d) connected downstream of the edge detectors (14, 14') is an evaluating circuit (16) which, based on the signals (S_{F1}, S_{F2}) supplied by the edge detectors (14, 14'), produces an output signal (AS) representative of the bus signal (BS);
(e) the evaluating circuit (16) only produces the output signal (AS) if after detection of a respective signal edge (F1) the voltage level (V) present at the bus (12) departs from the reference voltage level (V_{ref}) by at least the predetermined relative threshold value (ΔU_{S}) during a predetermined minimum duration (Tₘᵢₙ); and
(f) the evaluating circuit (16) only discontinues the output signal (AS) if after detection of a respective signal edge (F2) the voltage level (V) present at the bus (12) departs from the reference voltage level (V_{ref}) by at least the predetermined relative threshold value (ΔU_{S}) during a predetermined minimum duration (Tₘᵢₙ).

2. The circuit arrangement (10) according to claim 1, **characterized in that** the edge detector (14, 14') includes a memory cell (C) and a charge circuit (18) by which the memory cell (C) can be charged up to the quiescent voltage level of the bus (12) in order to produce the reference voltage level (V_{ref}), and that the edge detector (14, 14') further includes a comparator (22) comparing the voltage level (V) present at the bus (12) with the reference voltage level (V_{ref}) in order to supply the signal (S_{F1}, S_{F2}) representative of the occurrence of a signal edge (F1, F2) if the voltage level (V) present at the bus (12) departs from the reference voltage level (V_{ref}) by at least the predetermined relative threshold value (ΔU_{S}).

3. The circuit arrangement (10) according to either of the preceding claims, **characterized in that** the charge circuit (18) includes a differential amplifier (20) and a series circuit (R1, C) which is connected between the output of the differential amplifier (20) and ground (M) and is made up of a first resistor (R1) provided on the amplifier output side and a capacitor (C) constituting the memory cell and connected with ground (M), that a first input of the differential amplifier (20) is acted upon by the voltage level (V) at the bus (12) and the second input thereof is connected with the node (S1), supplying the reference voltage level (V_{ref}), between the first resistor (R1) and the capacitor (C), that connected between the first input of the differential amplifier (20) and ground (M) is a series circuit (D, R2) which is made up of a diode (D) provided on the amplifier input side and determining the relative threshold value (ΔU_{S}) and a second resistor (R2) connected with ground (M), and that a first input of the comparator (22) is connected with the node (S2) between the diode (D) and the second resistor (R2) and the second input thereof is connected with the node (S1) between the first resistor (R1) and the capacitor (C).

## Revendications

1. Circuit (10) pour la réception d'un signal (BS) transmis sous la forme d'une variation du niveau de tension sur un bus (12) avec deux lignes de bus transmettrices de signal (12a, 12b), ayant les caractéristiques suivantes :
a) à chaque ligne de bus transmettrice de signal (12a, 12b) sont affectés deux détecteurs de flanc (14, 14'), dont le premier délivre un signal (S_{F1}) représentatif de l'apparition d'un flanc de signal positif (F1) et le second délivre un signal (S_{F2}) représentatif de l'apparition d'un flanc de signal négatif (F2);
b) les détecteurs de flanc (14, 14') délivrent un signal (S_{F1}, S_{F2}) représentatif de l'apparition d'un flanc de signal (F1, F2) lorsque le niveau de tension (V) s'appliquant au bus (12) varie brusquement d'au moins une valeur de seuil relative prédéterminée (ΔU_{S}) par rapport à un niveau de tension de référence (V_{réf});
c) le niveau de tension de référence (V_{réf}) est adapté en continu au niveau de tension de repos du bus (12);
d) en aval des détecteurs de flanc (14, 14') est connecté un circuit d'exploitation (16) qui génère un signal de sortie (AS) représentatif du signal de bus (BS) en partant des signaux (S_{F1}, S_{F2}) délivrés par les détecteurs de flanc (14, 14');
e) le circuit d'exploitation (16) ne génère le signal de sortie (AS) que si, après la détection d'un flanc de signal concerné (F1), le niveau de tension (V) s'appliquant au bus (12) s'écarte du niveau de tension de référence (V_{réf}) pendant une durée minimale prédéterminée (Tₘᵢₙ) d'au moins la valeur de seuil relative prédéterminée (ΔU_{S}); et
f) le circuit d'exploitation (16) n'enlève le signal de sortie (AS) que si, après la détection d'un flanc de signal concerné (F2), le niveau de tension (V) s'appliquant au bus (12) s'écarte du niveau de tension de référence (V_{réf}) pendant une durée minimale prédéterminée (Tₘᵢₙ) d'au moins la valeur de seuil relative prédéterminée (ΔU_{S}).

2. Circuit (10) selon la revendication 1, **caractérisé en ce que** le détecteur de flanc (14, 14') contient un élément de mémoire (C) et un circuit de chargement (18), par lequel l'élément de mémoire (C) peut être chargé au niveau de tension de repos du bus (12), afin de générer le niveau de tension de référence (V_{réf}) et **en ce que** le détecteur de flanc (14, 14') contient en outre un comparateur (22), qui compare le niveau de tension (V) s'appliquant au bus (12) au niveau de tension de référence (V_{réf}) afin de délivrer le signal (S_{F1}, S_{F2}) représentatif de l'apparition d'un flanc de signal (F1, F2) lorsque le niveau de tension (V) s'appliquant au bus (12) s'écarte du niveau de tension de référence (V_{réf}) d'au moins la valeur de seuil relative prédéterminée (ΔU_{S}).

3. Circuit (10) selon l'une quelconque des revendications précédentes, **caractérisé en ce que** le circuit de chargement (18) contient un amplificateur différentiel (20) et un circuit en série (R1, C) situé entre sa sortie et la masse (M) et constitué d'une première résistance (R1) disposée sur le côté de la sortie de l'amplificateur et d'un condensateur (C) mis à la masse (M) et formant l'élément de mémoire, **en ce qu'**une première entrée de l'amplificateur différentiel (20) est alimentée par le niveau de tension (V) s'appliquant au bus (12) et sa seconde entrée, à laquelle le point de circuit (S1) délivrant le niveau de tension de référence (V_{réf}) est connecté entre la première résistance (R1) et le condensateur (C), **en ce qu'**il est connecté entre la première entrée de l'amplificateur différentiel (20) et la masse (M) un circuit en série (D, R2) constitué, côté entrée de l'amplificateur, d'une diode (D) déterminant la valeur de seuil relative (ΔU_{S}) et d'une seconde résistance (R2) mise à la masse (M) et **en ce qu'**une première entrée du comparateur (22) est raccordée au point de circuit (S2) situé entre la diode (D) et la seconde résistance (R2) et dont la seconde entrée est connectée au point de circuit (S1) situé entre la première résistance (R1) et le condensateur (C).
